(19) Europäisches Patentamt / European Patent Office / Office européen des brevets

(11) **EP 4 761 115 A1**

(12) **DEMANDE DE BREVET EUROPEEN**

(43) Date de publication:
**17.06.2026 Bulletin 2026/25**

(21) Numéro de dépôt: **25219652.2**

(22) Date de dépôt: **01.12.2025**

(51) Classification Internationale des Brevets (IPC):
*H03L 7/083* (2006.01)   *H03L 7/091* (2006.01)
*H03L 7/099* (2006.01)   *H03L 7/24* (2006.01)

(52) Classification Coopérative des Brevets (CPC):
**H03L 7/083; H03L 7/091; H03L 7/099; H03L 7/24;**
H03B 2200/0074; H03L 2207/06

(84) Etats contractants désignés:
**AL AT BE BG CH CY CZ DE DK EE ES FI FR GB
GR HR HU IE IS IT LI LT LU LV MC ME MK MT NL
NO PL PT RO RS SE SI SK SM TR**
Etats d'extension désignés:
**BA**
Etats de validation désignés:
**GE KH LA MA MD TN**

(30) Priorité: **10.12.2024 FR 2413821**

(71) Demandeur: **Commissariat à l'Energie Atomique
et aux Energies
Alternatives
75015 Paris (FR)**

(72) Inventeurs:
• **GONZALEZ JIMENEZ, José-Luis
38054 Grenoble cedex 09 (FR)**
• **DEHOS, Cedric
38054 Grenoble cedex 09 (FR)**

(74) Mandataire: **Cabinet Beaumont
4, Place Robert Schuman
B.P. 1529
38025 Grenoble Cedex 1 (FR)**

(54) **DISPOSITIF DE GÉNÉRATION DE SIGNAL AVEC AJUSTEMENT DE PHASE**

(57) Dispositif de génération de signal (100), comprenant :
- un oscillateur pulsé (102) générant un signal TORP de fréquence égale à $M.F_{Ref}$ ;
- un premier ILO (108) comprenant deux sorties sur lesquelles des signaux périodiques $V_{out+}$ et $V_{out-}$ de fréquence égale à $N.F_{Ref}$ et déphasés de 180° l'un par rapport à l'autre sont délivrés ;
- un premier échantillonneur (110) échantillonnant les signaux $V_{out+}$ et $V_{out-}$ à la fréquence $F_{Ref}$ ;
- un premier intégrateur (114) délivrant des signaux $V_{o+}$ et $V_{o-}$ résultant d'une intégration des signaux $V_{out+}$ et $V_{out-}$ échantillonnés ;
- un premier circuit de conversion (118) comprenant une entrée de commande recevant une tension de décalage $V_{off}$, et délivrant un signal de sortie de valeur proportionnelle à la différence de tension $(V_{off} + V_{o+}) - (V_{off} + V_{o-})$ et appliqué sur une entrée de contrôle du premier ILO.

Fig. 1

**Description**

Domaine technique

La présente description concerne de façon générale le domaine de la génération de signaux, par exemple pour des systèmes de communication ou pour des systèmes radar et/ou de détection.

Technique antérieure

La génération de signaux modulés et/ou à ondes entretenues, ou continues (CW ou « Continuous Wave » en anglais), dans les circuits radiofréquences (RF ou « Radio Frequency » en anglais) est généralement mise en œuvre à l'aide d'une boucle à verrouillage de phase (PLL ou « Phase-Locked Loop » en anglais) qui intègre un oscillateur commandé en tension (VCO ou « Voltage-Controlled Oscillator » en anglais) ou un oscillateur commandé numériquement (DCO ou « Digital Controlled Oscillator » en anglais) dans une boucle de rétroaction. Dans cette boucle, la phase d'un signal de référence externe appliqué en entrée de la PLL est comparée à celle d'un signal similaire à celui délivré en sortie de l'oscillateur mais dont la fréquence est divisée par rapport à celle du signal délivré en sortie de l'oscillateur.

La boucle formée par la PLL permet de régler la fréquence de l'oscillateur à un multiple entier ou une fraction entière de la fréquence du signal de référence. Ce facteur de multiplication ou de division correspond au rapport entre la fréquence souhaitée de l'oscillateur et la fréquence du signal de référence. Le signal de sortie généré, qui correspond au signal de sortie de l'oscillateur, est généralement appelé signal d'oscillateur local (LO ou « Local Oscillator » en anglais).

Ce signal LO peut être utilisé pour piloter d'autres circuits afin, par exemple, de moduler un signal de communication.

Le facteur de multiplication, ou rapport de division, de la PLL peut également être modifié dynamiquement pour mettre en œuvre une modulation de fréquence directement sur le signal de sortie de la PLL. Un exemple de cette technique est la génération d'un signal à onde continue modulée en fréquence (FMCW ou « Frequency Modulated Continuous Wave » en anglais) utilisé notamment dans les radars et formant une rampe de fréquence variant linéairement dans le temps entre deux fréquences extrêmes $f_{min}$ et $f_{max}$.

Dans certaines applications telles que les émetteurs-récepteurs radars multistatiques ou à antennes réseaux à commande de phase analogique ou mixte, plusieurs antennes émettent ou reçoivent le même signal modulé avec des ajustements de phase différents entre elles afin de mettre en œuvre une formation de faisceaux (« beamforming » en anglais) ou une détection d'angle d'arrivée des signaux. Une possibilité pour obtenir ces valeurs de phase différentes pour chacun des trajets d'antenne consiste à insérer, en série dans le chemin du signal entre l'antenne et les amplificateurs d'émission ou de réception, un déphaseur commandable. Une autre possibilité consiste à insérer, sur le trajet du signal LO, un déphasage commandable, de sorte que le déphasage introduit dans les différents signaux LOs utilisés dans l'émetteur ou le récepteur connecté aux antennes soit appliqué au signal modulé pendant le mélange avec le signal LO.

Le document de Kanoun, M. et al., "A 5.8 GHz fully integrated BiCMOS SiGe:C injection-locked-oscillator-based active phase shifter for energy beamforming", Analog Integr Circ Sig Process 106, 363-374 (2021), décrit une mise en œuvre d'un déphasage sur un signal LO à l'aide d'un oscillateur verrouillé en injection (ILO, ou « Injection-Locked Oscillator » en anglais). Dans ce document, une combinaison d'un premier déphasage fin et d'un deuxième déphasage plus important que le premier est réalisée sur un signal d'entrée de fréquence égale à environ 5 GHz. Le premier déphasage est obtenu par l'ajustement de la tension de commande $V_{tune}$ appliquée sur l'ILO, ce qui fait varier la fréquence d'auto-oscillation $f_0$ de l'ILO et permet d'introduire une différence de fréquence par rapport à la fréquence du signal d'injection appliqué en entrée de l'ILO. Si cette différence de fréquence reste dans la bande de verrouillage de l'ILO, celui-ci se verrouille sur la fréquence d'injection, avec un déphasage proportionnel à cette différence de fréquence. Ce premier déphasage peut couvrir une gamme de valeur allant de -45° à +45°. Le deuxième déphasage est mis en œuvre à l'aide d'un filtre polyphase comprenant différents chemins de connexion entre l'entrée et la sortie du filtre qui sont sélectionnables et appliquant des valeurs de déphasage fixes différentes, par exemple des multiples de 90°. Ces deux déphasages s'ajoutent l'un à l'autre pour obtenir en sortie un déphasage pouvant aller de -180° à +180°.

Un inconvénient de cette solution est que le réglage précis du premier déphasage nécessite de connaître la valeur exacte de la fréquence d'auto-oscillation $f_0$ de l'ILO. Or, la fréquence d'auto-oscillation $f_0$ de l'ILO est sensible aux variations PVT (« Process, Voltage, Température variations » en anglais) que subit l'ILO. De plus, cette solution nécessite que l'ILO soit verrouillé en fréquence sur le signal d'entrée, ce qui nécessite la présence d'un mécanisme pour détecter que cette condition soit remplie, ainsi qu'une méthode d'étalonnage au cas où cette condition n'est pas remplie afin de régler l'ILO dans les bonnes conditions de verrouillage. Enfin, ce type de déphasage de signal LO fait appel à des ILOs verrouillés à la même fréquence d'entrée que la fréquence souhaitée pour le signal LO. Dans le cas où ces ILOs sont intégrés dans une PLL pour synchroniser la sortie avec un multiple entier ou fractionnaire d'un signal de référence, le fonctionnement de la PLL affectera la valeur de phase du signal obtenu en sortie. L'ILO pourrait être placé après l'oscillateur de la PLL, mais cela implique que la génération de fréquence et le déphasage soient réalisés par des circuits séparés, ce qui augmenterait la consommation électrique.

Le document EP 3 624 343 A1 décrit une technique de détection de plage de déverrouillage et de configuration d'ILO pour faciliter son verrouillage sur un signal d'entrée, dans le cadre d'une architecture de génération de signal LO dont la fréquence est égale à un multiple entier du signal d'entrée. Dans le système décrit, le signal d'injection appliqué en entrée de l'ILO provient d'un oscillateur pulsé commandé par un signal de référence. La détection du verrouillage mise en œuvre est basée sur un sous-échantillonnage du signal de sortie de l'ILO à l'aide du même signal de référence que celui commandant l'oscillateur pulsé, suivi d'un traitement analogique qui mesure le contenu spectral du signal sous-échantillonné à l'aide d'opérations de filtrage et d'intégration. Cette technique peut être utilisée pour régler l'ILO de sorte que sa fréquence d'auto-oscillation soit égale à la valeur de la fréquence de sortie souhaitée. Cependant, ce réglage se fait une fois et avant le début de son utilisation, c'est-à-dire lorsque l'ILO n'est pas utilisé dans le système de communication, car pour le calibrer, il doit être réglé sur sa plage de verrouillage et parfois, l'ILO n'est pas verrouillé sur le signal d'entrée. Une fois le point optimal trouvé, l'ILO est configuré pour fonctionner normalement. Toutefois, les variations de température ou de tension, appelées variations VT, peuvent faire dériver la valeur de la fréquence d'auto-oscillation de l'ILO et affecter la précision du déphasage obtenu. Afin de stabiliser la valeur de la fréquence d'auto-oscillation de l'ILO, l'ajout d'un mécanisme de suivi est donc nécessaire afin de compenser en permanence l'impact des variations VT sur l'ILO.

Le document de Yoo, Seyeon et al. "A Low-Integrated-Phase-Noise 27-30-GHz Injection-Locked Frequency Multiplier With an Ultra-Low-Power Frequency-Tracking Loop for mm-Wave-Band 5G Transceivers." IEEE Journal of Solid-State Circuits 53 (2018): 375-388, décrit la mise en œuvre d'un suivi continu et une compensation de la valeur de la fréquence d'auto-oscillation d'un ILO. Le circuit qui implémente cette fonction est nommé FTL (« Frequency Tracking Loop » en anglais) et compare les aires des régions sous deux signaux de sortie complémentaires de l'ILO en les intégrant lors d'une courte impulsion provenant de l'entrée de synchronisation de l'ILO. Lorsque l'aire des deux régions est la même, cela signifie que l'impulsion est alignée en phase avec les signaux de sortie. Si la fréquence d'auto-oscillation de l'ILO dérive dans un sens ou dans l'autre par rapport à la valeur optimale attendue, la différence de phase entre l'impulsion d'entrée et les deux signaux de sortie complémentaires de l'ILO engendre des aires de taille différente sous ces deux signaux. Cette technique peut être utilisée pour obtenir une tension proportionnelle à la différence de phase (y compris le signe) utilisée ensuite dans une boucle de rétroaction pour régler l'ILO de sorte sa fréquence d'auto-oscillation redevienne optimale.

Cette technique nécessite que la fréquence du signal d'injection appliquée en entrée de l'ILO soit égale à la fréquence d'auto-oscillation de l'ILO. Aucun oscillateur pulsé n'est présent à l'entrée de l'ILO, de sorte que le facteur de multiplication de fréquence pouvant être obtenu est limité à une très petite valeur entière, généralement inférieure ou égale à 3. Le circuit FTL comporte une paire de commutateurs, un intégrateur passe-bas composé d'une résistance série et d'un condensateur parallèle, et d'un amplificateur d'erreur, correspondant à un amplificateur différentiel de conversion tension - courant, ou amplificateur de tension à courant (« V-to-I converter » en anglais, ou amplificateur différentiel à transconductance) piloté par deux signaux intégrateurs. Le signal d'erreur obtenu en sortie de l'amplificateur est un courant servant à charger ou à décharger le condensateur de boucle. La boucle est active une fois que le verrouillage est atteint et que le condensateur est chargé à la tension de réglage optimale. Si la fréquence d'auto-oscillation de l'ILO s'écarte de la valeur souhaitée, la boucle compense alors l'écart et règle la tension de commande de l'ILO pour maintenir le signal d'erreur égal à zéro.

Le document US 2023/224138 A1 décrit l'utilisation d'un circuit FTL dans une PLL utilisant un deuxième VCO recevant en entrée d'injection des signaux de sorties d'un oscillateur pulsé. Le circuit utilise l'oscillateur pulsé pour implémenter un détecteur de phase à multiplication de fréquence, mais n'injecte pas directement de signal dans le VCO présent dans la PLL. Un circuit FTL est utilisé pour régler la fréquence d'auto-oscillation de l'oscillateur pulsé de sorte que le signal de sortie du détecteur de phase soit aligné en phase avec le signal du VCO de la PLL, ces deux signaux ayant la même fréquence.

Le document de L.-Y. Chen et al., "A Ka-Band 256-QAM Ninefold Sub-Harmonically Injection-Locked CMOS I/Q Modulator Using Pulsed Oscillator", 2024 IEEE/MTT-S International Microwave Symposium - IMS 2024, Washington, DC, USA, 2024, pp. 50-53, décrit l'utilisation d'un circuit FTL pour maintenir une condition d'injection optimale pour un ILO. L'entrée d'un tel ILO est couplée à la sortie d'un oscillateur pulsé. Ce circuit est utilisé pour suivre et régler la valeur de la fréquence d'auto-oscillation de l'ILO de sorte que la courbe de sensibilité soit alignée avec le multiple entier de la fréquence de référence.

Dans toutes les structures précédemment décrites, un circuit est utilisé pour aligner les phases d'entrée et de sortie d'un ILO de sorte que sa fréquence d'auto-oscillation ou une harmonique inférieure soit exactement alignée sur un multiple de la fréquence du signal de référence appliqué en entrée. Cependant, aucune de ces structures ne permet une génération de signal avec un contrôle du déphasage entre le signal de sortie et le signal d'entrée à une valeur souhaitée autre qu'une valeur nulle.

Résumé de l'invention

Il existe un besoin de proposer un dispositif de génération de signal ne présentant pas au moins une partie des inconvénients des structures connues.

Un mode de réalisation pallie tout ou partie des inconvénients des solutions connues et propose un dispositif de génération de signal, comprenant au moins :

- un oscillateur pulsé configuré pour recevoir en entrée un signal périodique de fréquence $F_{Ref}$ et générer sur une sortie un signal TORP correspondant à un train d'oscillations de fréquence égale à $M.F_{Ref}$, de durée inférieure à $T_{Ref} = 1/F_{Ref}$ et répété périodiquement à la fréquence $F_{Ref}$, avec M nombre entier supérieur à 1 ;

- un premier oscillateur verrouillé par injection comprenant au moins une entrée d'injection couplée à la sortie de l'oscillateur pulsé et comprenant au moins deux sorties sur lesquelles des signaux périodiques $V_{out+}$ et $V_{out-}$ de fréquence égale à $N.F_{Ref}$, avec N nombre entier supérieur à 1, et déphasés de 180° l'un par rapport à l'autre sont destinés à être délivrés ;

- un premier échantillonneur configuré pour échantillonner les signaux $V_{out+}$ et $V_{out-}$ à la fréquence $F_{Ref}$ ;

- un premier intégrateur configuré pour délivrer en sortie des signaux $V_{o+}$ et $V_{o-}$ résultant chacun d'une intégration d'un des signaux $V_{out+}$ et $V_{out-}$ échantillonnés à la fréquence $F_{Ref}$ ;

- un premier circuit de conversion comprenant au moins une entrée de commande configurée pour recevoir au moins une tension de décalage $V_{off}$, et configuré pour délivrer un signal de sortie de valeur proportionnelle à la différence de tension $(V_{off} + V_{o+}) - (V_{off} + V_{o-})$ et destiné à être appliqué sur une entrée de contrôle du premier oscillateur verrouillé par injection.

Selon un mode de réalisation particulier, le premier circuit de conversion comporte au moins un amplificateur de tension à courant.

Selon un mode de réalisation particulier, le premier circuit de conversion comporte deux entrées de commande configurées pour recevoir chacune l'une des tensions de décalage $V_{off+}$ et $V_{off-}$, et est configuré pour délivrer le signal de sortie de valeur proportionnelle à la différence de tension $(V_{off+} + V_{o+}) - (V_{off-} + V_{o-})$ .

Selon un mode de réalisation particulier, le premier échantillonneur comporte au moins deux commutateurs configurés pour être commandés à la fréquence $F_{Ref}$ et recevoir chacun en entrée l'un des signaux $V_{out+}$ et $V_{out-}$.

Selon un mode de réalisation particulier, le premier intégrateur comporte au moins deux capacités électriques comprenant chacune une première électrode sur laquelle l'un des signaux $V_{out+}$ et $V_{out-}$ échantillonnés est destiné à être appliqué et une deuxième électrode sur laquelle un potentiel électrique de référence est destiné à être appliqué.

Selon un mode de réalisation particulier, le dispositif de génération de signal comporte en outre un premier circuit de stockage d'une tension de commande du premier oscillateur verrouillé par injection, configuré pour appliquer ladite tension de commande sur l'entrée de contrôle du premier oscillateur verrouillé par injection.

Selon un mode de réalisation particulier, le premier circuit de stockage comporte au moins une capacité électrique.

Selon un mode de réalisation particulier, le dispositif de génération de signal comporte en outre un premier circuit d'initialisation de la valeur de la tension de commande stockée dans le premier circuit de stockage.

Selon un mode de réalisation particulier, le premier circuit d'initialisation est configuré pour mettre en œuvre une phase de calibration du dispositif de génération de signal au cours de laquelle les étapes suivantes sont mises en œuvre :

- déconnecter le premier circuit de stockage vis-à-vis d'une sortie du premier circuit de conversion, et déconnecter les sorties du premier oscillateur verrouillé par injection vis-à-vis d'entrées du premier échantillonneur ;
- coupler un premier circuit de contrôle entre les sorties du premier oscillateur verrouillé par injection et le premier circuit de stockage ;
- calculer et stocker, dans le premier circuit de stockage, une valeur de tension d'initialisation telle que son application sur l'entrée de contrôle du premier oscillateur verrouillé par injection engendre un verrouillage du premier oscillateur verrouillé par injection sur la fréquence $N.F_{Ref}$ et qu'un déphasage entre les signaux périodiques $V_{out+}$ et $V_{out-}$ et le signal TORP soit nul.

Selon un mode de réalisation particulier, le premier circuit de contrôle comporte au moins :

- un filtre intégrateur configuré pour réaliser un filtrage passe-haut ou passe-bande des signaux $V_{out+}$ et $V_{out-}$ ;
- un comparateur configuré pour comparer un signal de sortie du filtre intégrateur avec une valeur seuil ;
- un dispositif de contrôle configuré pour déterminer des valeurs maximum et minimum de la tension de commande du premier oscillateur verrouillé par injection pour lesquelles le premier oscillateur verrouillé par injection peut se verrouiller en fréquence, et pour déterminer la valeur de la tension d'initialisation qui est comprise entre ces valeurs maximum et minimum.

Selon un mode de réalisation particulier, le dispositif de génération de signal comporte en outre un circuit de mise en forme de signal configuré pour recevoir en entrée un signal sinusoïdal de fréquence $F_{Ref}$ et pour délivrer sur l'entrée de l'oscillateur pulsé le signal périodique de fréquence $F_{Ref}$ sous la forme d'un signal carré.

Selon un mode de réalisation particulier, le dispositif de génération de signal comporte en outre une ligne à retard contrôlé couplée à l'entrée de l'oscillateur pulsé et configurée pour appliquer sur le signal périodique de fréquence $F_{Ref}$ un déphasage égal à 0° ou 90° ou 180° ou 270°.

Selon un mode de réalisation particulier, le dispositif de génération de signal comprend au moins un deuxième oscillateur verrouillé par injection comportant au moins deux entrées d'injection couplées aux sorties du premier oscillateur verrouillé par injection.

Selon un mode de réalisation particulier :

- le premier oscillateur verrouillé par injection est multi-phasé et comporte plusieurs sorties sur lesquelles des signaux sont délivrés avec des déphasages multiples de 90°, ou
- le deuxième oscillateur verrouillé par injection fait partie d'une boucle de rétroaction comportant au moins un deuxième échantillonneur, un deuxième intégrateur, et un deuxième circuit de conversion, couplés entre eux de manière analogue au premier échantillonneur, au premier intégrateur et au premier circuit de conversion avec le premier oscillateur verrouillé par injection.

Il est également proposé un dispositif de génération multi-signaux comprenant au moins plusieurs dispositifs de génération de signal configurés pour recevoir en entrée un même signal périodique de fréquence $F_{Ref}$ et différentes tensions de décalage $V_{off}$ chacune destinée à l'un des dispositifs de génération de signal.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

- la figure 1 représente un exemple de dispositif de génération de signal selon un premier mode de réalisation ;

- la figure 2 représente une variante de réalisation d'un circuit de conversion d'un dispositif de génération de signal ;

- la figure 3 représente une valeur de déphasage obtenue dans un ILO du dispositif de génération de signal en fonction de la valeur de la tension de commande appliquée en entrée de cet ILO ;

- la figure 4 représente un exemple de dispositif de génération de signal selon un deuxième mode de réalisation ;

- la figure 5 représente un exemple de dispositif de génération de signal selon un troisième mode de réalisation ;

- la figure 6 représente un exemple de dispositif de génération de signal selon un quatrième mode de réalisation ;

- la figure 7 représente un exemple de dispositif de génération multi-signaux selon un mode de réalisation particulier.

Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques. Sur les figures, afin de faciliter leur lecture, les différents éléments ne sont pas représentés à la même échelle les uns par rapport aux autres.

Par souci de clarté, seuls les étapes et éléments utiles à la compréhension des modes de réalisation décrits ont été représentés et sont détaillés. En particulier, différents éléments (oscillateur pulsé, ILOs, circuit de conversion, amplificateur, circuit d'initialisation de valeur de tension de commande d'ILO, filtre intégrateur, comparateur, système de contrôle, circuit de mise en forme de signal, ligne à retard contrôlé, etc.) ne sont pas détaillés. L'homme du métier sera à même de réaliser de manière détaillée ces éléments à partir de la description fonctionnelle donnée ici.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés (en anglais "coupled") entre eux, cela signifie que ces deux éléments peuvent être connectés ou être reliés par l'intermédiaire d'un ou plusieurs autres éléments. En outre, les termes « couplé », « relié » et « connecté » sont utilisés ici pour désigner des couplages, ou des liaisons, ou des connexions, électriques.

Sauf précision contraire, les expressions "environ", "approximativement", "sensiblement", et "de l'ordre de" signifient à 10 % près, de préférence à 5 % près.

Sans indication contraire, les gammes de valeurs indiquées incluent les bornes de ces gammes.

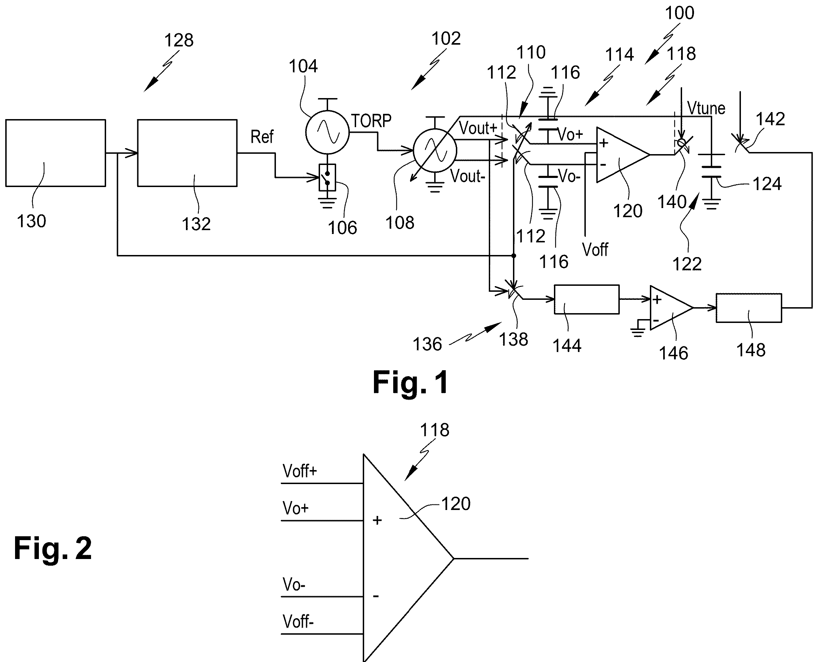

Un dispositif 100 de génération de signal selon un premier mode de réalisation est décrit ci-dessous en lien avec la figure 1.

Le dispositif 100 comprend un oscillateur pulsé 102 configuré pour recevoir en entrée un signal de référence « Ref » périodique de fréquence $F_{Ref}$ et générer sur une sortie un signal « TORP » correspondant à un train d'oscillations de fréquence égale à $M.F_{Ref}$, de durée inférieure à $T_{Ref} = 1/F_{Ref}$, et répété périodiquement à la fréquence $F_{Ref}$, avec M nombre entier supérieur à 1. A titre d'exemple, la valeur de la fréquence $F_{Ref}$ peut être comprise entre quelques centaines de MHz et quelques GHz, et la valeur de M est par exemple comprise entre 15 et 50.

Selon un exemple de réalisation correspondant à celui représenté sur la figure 1, l'oscillateur pulsé 102 peut comporter un oscillateur 104 de type VCO contrôlé en tension par un signal de contrôle (non visible sur la figure 1), et des moyens d'alimentation électrique commandés 106 alimentant électriquement l'oscillateur 104 et qui sont commandés par le signal de référence Ref. Ces moyens 106 correspondent par exemple à une source de courant commandée fonctionnant comme un interrupteur interrompant périodiquement, avec une période égale à $T_{Ref}$, l'alimentation électrique de l'oscillateur 104. Cette source de courant commandée peut correspondre à un transistor MOS comportant une grille sur laquelle est appliqué le signal de référence Ref. De manière générale, ces moyens 106 peuvent comporter un interrupteur relié à une entrée d'alimentation électrique de l'oscillateur 104 et apte à être commandé par le signal de référence Ref.

Des détails de réalisation d'un tel oscillateur pulsé 102 ainsi que des variantes de réalisation de celui-ci sont par exemple décrits dans le document WO 2013/079685 A1. D'autres variantes de réalisation d'un tel oscillateur pulsé 102 sont possibles.

Le dispositif 100 comporte en outre un premier ILO 108 comprenant au moins une entrée d'injection couplée à la sortie de l'oscillateur pulsé 102 et sur laquelle le signal TORP est appliqué. Le premier ILO 108 comprend également deux sorties sur lesquelles des signaux périodiques $V_{out+}$ et $V_{out-}$ de fréquence égale à $N.F_{ref}$, avec N nombre entier supérieur à 1, et déphasés de 180° l'un par rapport à l'autre sont destinés à être délivrés. A titre d'exemple, la valeur de N peut être comprise entre 15 et 50.

Le dispositif 100 comporte en outre un premier échantillonneur 110 configuré pour échantillonner les signaux $V_{out+}$ et $V_{out-}$ à la fréquence $F_{ref}$. Selon un exemple de réalisation correspondant à celui représenté sur la figure 1, le premier échantillonneur 110 comporte au moins deux commutateurs 112, ou interrupteurs, configurés pour être commandés à la fréquence $F_{ref}$ et recevoir chacun en entrée l'un des signaux $V_{out+}$ et $V_{out-}$. L'entrée de chacun des commutateurs 112 est, dans cet exemple, couplée à l'une des sorties du premier ILO 108. D'autres variantes de réalisation du premier échantillonneur 110 sont possibles.

Le dispositif 100 comporte en outre un premier intégrateur 114 configuré pour délivrer en sortie des signaux $V_{o+}$ et $V_{o-}$ résultant chacun d'une intégration d'un des signaux $V_{out+}$ et $V_{out-}$ échantillonnés à la fréquence $F_{ref}$. Selon un exemple de réalisation correspondant à celui représenté sur la figure 1, le premier intégrateur 114 comporte au moins deux capacités électriques 116 comprenant chacune une première électrode sur laquelle l'un des signaux $V_{out+}$ et $V_{out-}$ échantillonnés est destiné à être appliqué et une deuxième électrode sur laquelle un potentiel électrique de référence, par exemple la masse du dispositif 100, est destiné à être appliqué. Le premier intégrateur 114 peut également être vu comme un filtre passe-bas appliqué sur les signaux $V_{out+}$ et $V_{out-}$ échantillonnés. En variante, le premier intégrateur 114 peut également comporter au moins deux résistances électriques comprenant chacune une première électrode couplée à l'un des interrupteurs 112 et une deuxième électrode couplée à la première électrode de l'une des capacités 116. D'autres variantes de réalisation du premier intégrateur 114 sont possibles.

Le dispositif 100 comporte en outre un premier circuit de conversion 118 comprenant au moins une entrée de commande configurée pour recevoir en entrée les signaux $V_{o+}$ et $V_{o-}$ sous forme de tensions et au moins une tension de décalage, ou d'offset, $V_{off}$, et pour délivrer un courant de sortie proportionnel à la différence de tensions $(V_{off} + V_{o+}) - (V_{off} + V_{o-})$. Ce courant de sortie est destiné à être converti en une tension de commande $V_{tune}$ qui sera appliquée sur une entrée de contrôle du premier ILO 108. Selon un exemple de réalisation correspondant à celui représenté sur la figure 1, le premier circuit de conversion 118 comporte au moins un amplificateur 120 différentiel de tension à courant, ou à transconductance. Cet amplificateur 120 comporte au moins deux entrées différentielles couplées aux sorties du premier intégrateur 114 sur lesquelles sont délivrés les signaux $V_{o+}$ et $V_{o-}$.

Dans une variante de réalisation, le premier circuit de conversion 118 comporte deux entrées de commande configurées pour recevoir chacune l'une des tensions d'offset, ou de décalage, $V_{off+}$ et $V_{off-}$, et est configuré pour délivrer le courant de sortie proportionnel à la différence de tension $(V_{off+} + V_{o+}) - (V_{off-} + V_{o-})$. La figure 2 représente schématiquement une telle variante, dans laquelle l'amplificateur 120 comporte, en plus des deux entrées différentielles sur lesquelles sont appliqués les tensions $V_{o+}$ et $V_{o-}$, deux entrées de commande sur lesquelles sont appliquées les tensions de décalage $V_{off+}$ et $V_{off-}$.

D'autres variantes de réalisation du premier circuit de conversion 118 sont possibles.

Dans l'exemple de réalisation décrit, le dispositif 100 comporte en outre un premier circuit de stockage 122 de la tension de commande $V_{tune}$ du premier ILO 108, configuré pour appliquer, lors du fonctionnement du dispositif 100, la tension de commande $V_{tune}$ sur l'entrée

de contrôle du premier ILO 108. Selon un exemple de réalisation correspondant à celui représenté sur la figure 1, le premier circuit de stockage 122 comporte au moins une capacité électrique 124 aux bornes de laquelle la tension de commande $V_{tune}$ est stockée. Sur l'exemple de la figure 1, une première électrode de la capacité 124 est couplée à la sortie du premier circuit de conversion 118, c'est-à-dire la sortie de l'amplificateur 120 dans cet exemple. Un potentiel électrique de référence, par exemple la masse du dispositif 100, est appliqué sur une deuxième électrode de la capacité 124. D'autres variantes de réalisation du premier circuit de stockage 122 sont possibles.

Dans l'exemple de réalisation décrit, le dispositif 100 comporte en outre un générateur 128 générant le signal de référence Ref et le délivrant en entrée de l'oscillateur pulsé 102. Dans l'exemple représenté sur la figure 1, le générateur 128 comporte une source 130 de signal sinusoïdal de fréquence $F_{ref}$, par exemple une PLL ou tout autre circuit de génération de signal sinusoïdal. Dans l'exemple de réalisation décrit, la source 130 sert également à fournir des signaux de commande de fréquence $F_{ref}$ et ayant différentes durées d'activation et de désactivation, comme par exemple les signaux de commande de commutation des commutateurs 112. En variante, la commutation des commutateurs 112 peut être commandée par des signaux de commande de fréquence $F_{ref}$ fournis par un autre circuit que le générateur 128.

Le générateur 128 comporte également un circuit 132 de mise en forme de signal configuré pour recevoir en entrée le signal sinusoïdal de fréquence $F_{ref}$ délivré par la source 130 et pour délivrer en sortie du générateur 128, le signal de référence Ref. Dans l'exemple de réalisation décrit, le circuit 132 est configuré pour délivrer le signal de référence Ref sous la forme d'un signal carré de fréquence $F_{ref}$. Selon une réalisation particulière, le circuit 132 peut être configuré pour pouvoir paramétrer le rapport cyclique de ce signal carré. Par exemple, le circuit 132 peut être configuré tel que la valeur du rapport cyclique du signal de référence Ref soit comprise entre 10% et 90%.

D'autres variantes de réalisation du générateur 128 sont possibles.

Dans le dispositif 100, l'oscillateur pulsé 102 couplé au premier ILO 108 peut servir à générer un signal à ondes entretenues en mettant en œuvre une multiplication de fréquence par nombre entier d'ordre élevé. L'oscillateur pulsé 102 génère le signal TORP qui contient des harmoniques multiples entières de la fréquence du signal de référence Ref, c'est-à-dire les fréquences (..., M-2, M-1, M, M+1, M+2, ...) . $F_{Ref}$. L'oscillateur pulsé 102 est synchronisé avec le signal de référence Ref appliqué à son entrée. La fréquence $M.F_{Ref}$ correspond à la raie de plus grande amplitude du spectre du signal de référence Ref, et ce spectre est centré sur la fréquence d'auto-oscillation $f_0$ de l'oscillateur 104. Les harmoniques d'amplitude maximale se trouvent autour de la fréquence d'auto-oscillation $f_0$. L'un de ces termes harmoniques (celui de fréquence $N.F_{Ref}$ dans l'exemple décrit) est sélectionné par le premier ILO 108, en fonction de la valeur de la tension de commande $V_{tune}$ appliquée sur l'entrée de contrôle du premier ILO 108. Dans une configuration particulière, l'harmonique sélectionnée par le premier ILO 108 correspond à la raie de plus grande amplitude du spectre du signal TORP, c'est-à-dire telle que N = M.

Le premier ILO 108 a sa propre fréquence d'auto-oscillation $f_0$. Cette fréquence $f_0$ définit le centre de la courbe de sensibilité du premier ILO 108. L'amplitude de cette courbe de sensibilité a une valeur minimale lorsque la fréquence du signal d'injection reçu par le premier ILO 108 est égale à la fréquence $f_0$, et augmente à mesure que la fréquence du signal d'injection s'éloigne de la valeur $f_0$. Le verrouillage du premier ILO 108 n'est possible que dans une certaine gamme de fréquences centrée sur $f_0$. Si l'amplitude du signal d'injection appliqué en entrée du premier ILO 108 dépasse l'amplitude de cette courbe de sensibilité du premier ILO 108 à la fréquence du signal d'injection, le premier ILO 108 se verrouille alors en fréquence sur le signal d'injection reçu et oscille à la fréquence de ce signal d'injection et non à sa propre fréquence d'auto-oscillation $f_0$. Lorsque le premier ILO 108 est verrouillé sur la fréquence $N.F_{Ref}$, les signaux de sortie du premier ILO 108 $V_{out+}$ et $V_{out-}$ oscillent à la fréquence $N.F_{Ref}$.

La différence de phase entre le signal d'injection appliqué en entrée du premier ILO 108 et le signal de sortie du premier ILO 108 dépend de la différence entre les fréquences $f_0$ et $N.F_{Ref}$. En ajustant la valeur de la fréquence d'auto-oscillation $f_0$ du premier ILO 108, un déphasage contrôlable peut être introduit entre le signal d'injection et le signal de sortie du premier ILO 108.

Afin de régler la phase du signal obtenu en sortie du dispositif 100, le premier échantillonneur 110, le premier intégrateur 114, le premier circuit de conversion 118 et le premier circuit de stockage 122 forment, dans le dispositif 100, une boucle de suivi de fréquence servant à définir le déphasage par rapport au signal de référence Ref appliqué en entrée de l'oscillateur pulsé 102. Les signaux $V_{out+}$ et $V_{out-}$ obtenus en sortie du premier ILO 108 sont échantillonnés et intégrés tel que les signaux $V_{o+}$ et $V_{o-}$ correspondent à l'aire, ou la surface, sous les signaux $V_{out+}$ et $V_{out-}$, respectivement. Dans l'exemple de réalisation décrit en lien avec la figure 1 dans lequel le premier échantillonneur 110 comporte les commutateurs 112 et dans lequel le premier intégrateur 114 comporte les capacités électriques 116, cela revient à réaliser une fonction intégrale sur les signaux $V_{out+}$ et $V_{out-}$ pendant la durée de fermeture des commutateurs 112. Les capacités 116 permettent de fournir des signaux de sortie $V_{o+}$ et $V_{o-}$ analogiques sous la forme de tensions proportionnelles à l'aire présente sous les courbes des signaux $V_{out+}$ et $V_{out-}$ pendant la durée de fermeture des commutateurs 112.

Ces deux signaux $V_{o+}$ et $V_{o-}$ sont comparés l'un à l'autre en appliquant sur chacun d'eux le signal de décalage $V_{off}$ ou l'un des deux signaux de décalage $V_{off+}$ et $V_{off-}$ par le premier circuit de conversion 118. Le courant d'erreur obtenu en sortie du premier circuit de conversion 118 est utilisé pour définir la valeur de la tension stockée dans le premier circuit de stockage 122 et destinée à commander le premier ILO 108. Le signal de décalage $V_{off}$ ou les signaux de décalage $V_{off+}$ et $V_{off-}$ permettent d'obtenir en sortie du premier circuit de conversion 118 un courant d'erreur tel que le déphasage entre le signal de référence Ref et les signaux de sortie du premier ILO 108 dépende de la valeur du ou des signaux de décalage. Le ou les signaux de décalage sont donc utilisés pour définir une condition d'équilibre pour la boucle de rétroaction, avec un déphasage entre l'entrée et la sortie de cette boucle qui est de valeur variable.

Dans le premier ILO 108, la différence de phase, appelée $\alpha$, entre le signal appliqué à son entrée et le signal obtenu en sortie dépend de différents paramètres du premier ILO 108: le facteur de qualité Q de l'oscillateur du premier ILO 108, le rapport entre l'amplitude E du signal de sortie du premier ILO 108 et celle $E_{inj}$ du signal d'injection (signal TORP) appliqué en entrée du premier ILO 108, et la différence relative entre la fréquence d'auto-oscillation $f_0$ du premier ILO 108 et celle du signal d'injection du premier ILO 108, c'est-à-dire le rapport $\Delta\omega_0/\omega_0$, avec $\omega_0 = 2\pi f_o$ et $\Delta\omega_0 = 2\pi(N.F_{Ref} - f_o)$. Ces paramètres sont liés entre eux par l'équation :

[Math 1]

$$sin(\alpha) = 2Q \frac{E.\Delta\omega_0}{E_{inj}.\omega_0}$$

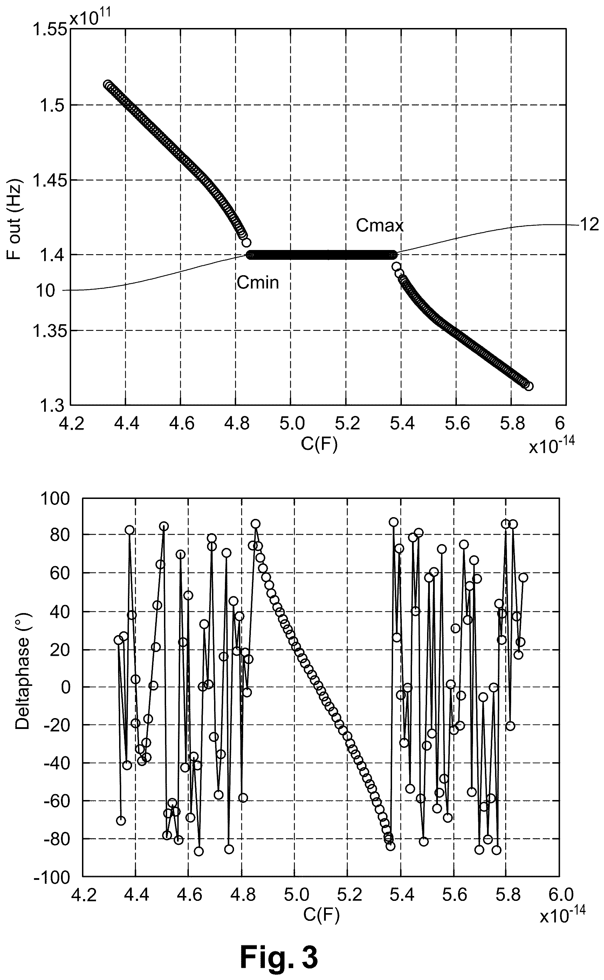

La forme de la fonction définissant la différence de phase $\alpha$ en fonction de ces paramètres correspond donc à une fonction de type arc sinus. La figure 3 représente la valeur de déphasage obtenue dans le premier ILO 108 en fonction de la valeur de capacité interne qui dépend de la tension de commande $V_{tune}$ appliquée en entrée du premier ILO 108. Cette valeur de capacité interne détermine la fréquence d'auto-oscillation $f_0$ du premier ILO 108. Sur cette figure, les références 10 et 12 désignent les valeurs limitent au-delà desquelles le verrouillage du premier ILO 108 n'est plus obtenu. Au-delà de ces valeurs, la phase tourne de façon asynchrone.

Si $\Delta\omega_0 = 0$, alors $\alpha = 0°$. Par conséquent, lorsque la fréquence d'auto-oscillation $f_0$ du premier ILO 108 est strictement égale à la fréquence de verrouillage du premier ILO 108 (N.$F_{ref}$), la différence de phase entre les signaux d'entrée et de sortie du premier ILO 108 est nulle. Dans le dispositif 100, la valeur de la tension de commande $V_{tune}$ appliquée sur l'entrée de commande du premier ILO 108 peut être choisie telle la fréquence d'auto-oscillation $f_0$ du premier ILO 108 soit différente de la fréquence de verrouillage du premier ILO 108 et permette d'avoir, en sortie, le déphasage souhaité par rapport au signal d'entrée.

Comme indiqué précédemment, le déphasage obtenu dépend également du facteur de qualité Q du premier ILO 108 et du rapport $E/E_{inj}$. Ces paramètres sont maintenus constant afin que le déphasage obtenu soit contrôlé en changeant la valeur de $f_0$.

Le déphasage $\alpha$ pouvant être obtenu peut être compris entre de -90° à +90°, ou de préférence compris entre environ -45° à +45° afin de limiter les risques de perdre le verrouillage en fréquence du premier ILO 108 et de rester dans une région de variation linéaire du déphasage en fonction de la tension de commande $V_{tune}$ appliquée sur le premier ILO 108.

Dans l'exemple de réalisation décrit, le dispositif 100 comporte en outre un circuit d'initialisation de la valeur de la tension de commande stockée dans le circuit 122. Ce circuit peut être configuré pour mettre en œuvre une phase de calibration du dispositif 100 au cours de laquelle les étapes suivantes sont mises en œuvre :

- déconnecter le premier circuit de stockage 122 vis-à-vis d'une sortie du premier circuit de conversion 118, et déconnecter les sorties du premier ILO 108 vis-à-vis d'entrées du premier échantillonneur 110 ;

- coupler un premier circuit de contrôle 136 entre les sorties du premier ILO 108 et le premier circuit de stockage 122 ;

- calculer et stocker, dans le premier circuit de stockage 122, une valeur de tension d'initialisation telle que son application sur l'entrée de contrôle du premier ILO 108 engendre un verrouillage du premier ILO 108 sur la fréquence N.$F_{Ref}$ et qu'un déphasage entre les signaux périodiques $V_{out+}$ et $V_{out-}$ et le signal TORP soit nul.

Dans l'exemple de réalisation représenté sur la figure 1, les étapes de découplage et de couplage indiquées ci-dessus sont mises en œuvre grâce :

- aux commutateurs 112 qui sont laissés à l'état ouvert lors de la phase de calibration, et

- à un commutateur 138 interposé entre l'entrée du premier circuit de contrôle 136 et l'une des sorties du premier ILO 108 et qui est mis à l'état fermé lors de la phase de calibration, et

- à un commutateur 140 interposé entre la sortie du premier circuit de conversion 118 et l'entrée du premier circuit de stockage 122 (c'est-à-dire entre la sortie de l'amplificateur 120 et la première électrode de la capacité 124 dans l'exemple décrit) et qui est mis à l'état ouvert lors de la phase de calibration, et

- à un commutateur 142 interposé entre la sortie du premier circuit de contrôle 136 et le premier circuit de stockage 122 (la première électrode de la capacité 124 dans l'exemple décrit) et qui est mis à l'état fermé lors de la phase de calibration.

Dans l'exemple de réalisation décrit, le premier circuit de contrôle 136 comporte au moins :

- un filtre intégrateur 144 configuré pour réaliser un filtrage passe-haut ou passe-bande de l'un des signaux $V_{out+}$ et $V_{out-}$ ;

- un comparateur 146 configuré pour comparer un signal de sortie du filtre intégrateur 144 avec une valeur seuil (correspondant, sur l'exemple de la figure 1, à une valeur d'un potentiel électrique de référence correspondant à la masse du dispositif 100) ;

- un dispositif de contrôle 148 configuré pour déterminer des valeurs maximum et minimum de la tension de commande du premier ILO 108 pour lesquelles le premier ILO 108 peut se verrouiller (correspondant aux valeurs de la tension de commande pour les points 10 et 12 de la courbe représentée sur la figure 3), et pour déterminer la valeur d'initialisation de $V_{tune}$.

Dans l'exemple de réalisation décrit, le premier circuit de stockage 122 est initialisé par le circuit 136 avec une valeur de sortie du premier circuit de conversion 118 après le verrouillage du premier ILO 108 sur la fréquence $N.F_{ref}$. Lors de cette phase de calibration, ou d'initialisation, les commutateurs 112 et 140 sont ouverts pendant une phase d'acquisition du verrouillage par le premier ILO 108. Après cette phase, ces commutateurs sont fermés afin de former une boucle de rétroaction qui stabilise la fréquence d'auto-oscillation du premier ILO 108 de manière à ce que le courant d'erreur obtenu en sortie du premier circuit de conversion 118 soit nul pour une valeur de déphasage souhaité du signal de sortie par rapport au signal de référence et qui a été défini via le choix de la ou des tensions de décalage appliquées sur le premier circuit de conversion 118.

A titre d'exemple, le dispositif de contrôle 148 peut mettre en œuvre, pour calculer la valeur de tension d'initialisation à stocker dans le premier circuit de stockage 122, un algorithme comportant les étapes suivantes :

- initialisation du premier circuit de stockage 122 à une valeur de tension minimale et déconnexion des circuits de déphasage et de suivi de l'étalonnage (premier échantillonneur 110, premier intégrateur 114 et premier circuit de conversion 118) ;

- augmentation de la valeur de la tension de commande du premier ILO 108 (en utilisant par exemple un convertisseur numérique analogique) jusqu'à ce qu'un signal de détection de verrouillage soit activé, et mémorisation de cette valeur qui correspond à la valeur minimale de $V_{tune}$ permettant le verrouillage en fréquence du premier ILO 108 (c'est-à-dire la valeur de la tension au point 10 de la figure 3) ;

- augmentation de la valeur de la tension de commande du premier ILO 108 jusqu'à ce que le signal de détection de verrouillage soit désactivé, et mémorisation de cette valeur qui correspond à la valeur maximale de $V_{tune}$ permettant le verrouillage en fréquence du premier ILO 108 (c'est-à-dire la valeur de la tension au point 12 de la figure 3) ;

- calcul et mémorisation, dans le premier circuit de stockage 122, de la valeur d'initialisation à partir des valeurs maximales et minimales de $V_{tune}$, par exemple telle qu'elle soit égale à la moyenne de ces deux valeurs, et déconnexion du premier circuit de contrôle 136 vis-à-vis des autres éléments du dispositif 100 ;

- reconnexion des circuits de déphasage et d'étalonnage précédemment déconnectés pour la phase de calibration.

Après la phase de calibration, le dispositif 100 est utilisé en déconnectant le premier circuit de contrôle 136 vis-à-vis des autres éléments du dispositif 100. La tension stockée dans le premier circuit de stockage 122 permet de fixer la courbe de sensibilité du premier ILO 108, qui est centrée sur la fréquence d'auto-oscillation du premier ILO 108, exactement à la fréquence $N.F_{ref}$, c'est-à-dire alignée sur la fréquence du signal d'entrée du premier ILO 108. La boucle formée se stabilise avec la tension de commande stockée dans le premier circuit de stockage 122 et qui est appliquée sur l'entrée de commande du premier ILO 108, qui correspond à la différence de phase souhaitée entre l'entrée et la sortie du premier ILO 108.

Ainsi, en paramétrant la ou les tensions de décalage appliquées sur le premier circuit de conversion 118, différentes valeurs phases ou de déphasages peuvent être appliquées entre le signal d'entrée et le signal de sortie du dispositif 100. Les signaux d'intérêts fournis par le dispositif 100, ayant la fréquence et la phase souhaitées, correspondent aux signaux $V_{out+}$ et $V_{out-}$ obtenus en sortie du premier ILO 108.

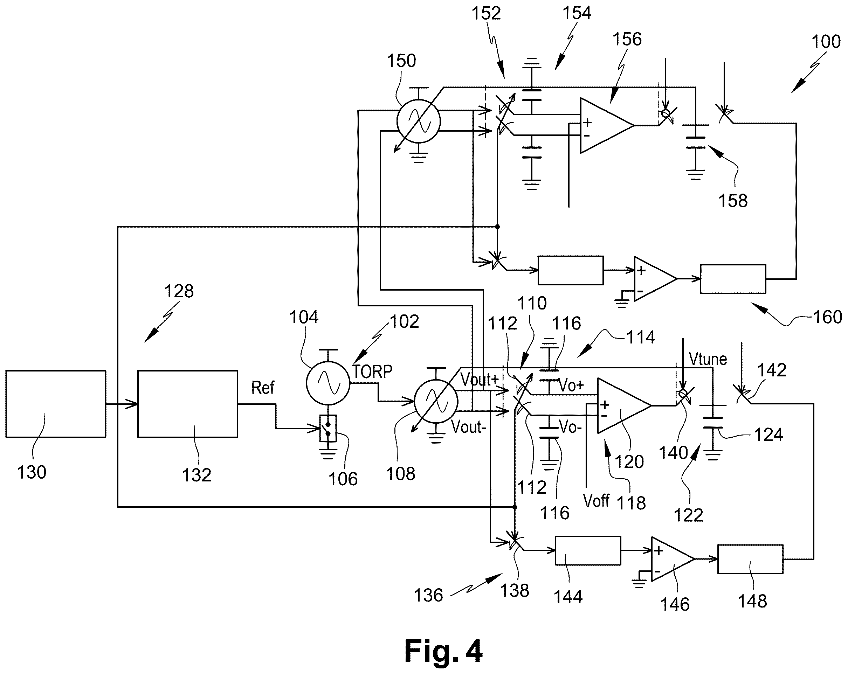

La figure 4 représente schématiquement le dispositif 100 selon un deuxième mode de réalisation.

Dans ce deuxième mode de réalisation, le dispositif 100 comprenant au moins un deuxième ILO 150 comportant au moins deux entrées d'injection couplées aux sorties du premier ILO 108.

Le dispositif 100 selon le deuxième mode de réalisation comporte également un deuxième échantillonneur 152 par exemple similaire au premier échantillonneur 110 et couplé aux sorties du deuxième ILO 150, un deuxième intégrateur 154 par exemple similaire au premier intégrateur 114 et couplé aux sorties du deuxième échantillonneur 152, un deuxième circuit de conversion 156 par exemple similaire au premier circuit de conversion 118 et couplé aux sorties du deuxième intégrateur 154, un deuxième circuit de stockage 158 par exemple similaire au premier circuit de stockage 122 et couplé à la sortie du deuxième circuit de conversion 156, et un circuit d'initialisation de la valeur stockée dans le deuxième circuit de stockage 158 par exemple similaire au circuit d'initialisation de la valeur stockée dans le premier circuit de stockage 122 et comprenant un deuxième circuit de contrôle 160 par exemple similaire au premier circuit de contrôle 136. Dans ce deuxième mode de réalisation, le deuxième ILO 150 fait partie d'une boucle comportant le deuxième échantillonneur 152, le deuxième intégrateur 154, le deuxième circuit de conversion 156 et le deuxième circuit de stockage 158, couplés entre eux de manière analogue au premier échantillonneur 110, au premier intégrateur 114, au premier circuit de conversion 118 et au premier circuit de stockage 122 avec le premier ILO 108.

Lors du fonctionnement du dispositif 100 selon ce deuxième mode de réalisation, la boucle de contrôle et de suivi de phase du signal délivré par le premier ILO 108 peut être d'abord activée de manière à ce que le premier ILO 108 se retrouve dans un état pour lequel le signal de sortie du premier ILO 108 soit en phase avec le signal de référence (ce qui correspond à une tension de décalage $V_{off}$ nulle appliquée sur l'amplificateur 120). Ensuite, la boucle de contrôle et de suivi de phase du deuxième ILO 150 peut être activée de manière à obtenir le déphasage souhaité en sortie du deuxième ILO 150.

Dans l'exemple ci-dessus, les deux boucles de contrôle de phase et de suivi de fréquence de chacun des ILOs 108, 150 sont activées l'une après l'autre. En variante, ces boucles de contrôle peuvent fonctionner simultanément.

Lors de la phase de calibration, les étapes de l'algorithme mis en œuvre par le premier dispositif de contrôle 148 peuvent être mises en œuvre pour le premier ILO 108, puis des étapes analogues peuvent être mises en œuvre par le deuxième dispositif de contrôle du deuxième circuit de contrôle 160 pour le deuxième ILO 150. Les circuits de déphasage et de suivi de l'étalonnage peuvent fonctionner en arrière-plan pour les deux ILOs 108, 150 simultanément.

L'utilisation de plusieurs ILOs dans le dispositif 100 permet de supprimer les signaux parasites pouvant apparaître en sortie autour de la fréquence N.$F_{ref}$. Dans l'exemple décrit en lien avec la figure 4, deux ILOs sont utilisés en cascade. En variante, un plus grand nombre d'ILOs couplés en cascade peuvent être utilisés.

Dans ce deuxième mode de réalisation, chacun des ILOs 108, 150 peut introduire un déphasage différent entre son entrée et sa sortie, et le déphasage global entre la sortie du deuxième ILO 150 et le signal de référence correspond au déphasage cumulé sur l'ensemble de la chaîne formée dans le dispositif 100. Le mécanisme de contrôle et de suivi de phase décrit précédemment pour le premier mode de réalisation peut être appliqué à chacun des ILOs 108, 150 du dispositif 100 selon le deuxième mode de réalisation.

Dans le dispositif 100 selon le deuxième mode de réalisation, les signaux d'intérêts ayant la fréquence et la phase souhaitées correspondent aux signaux obtenus en sortie du deuxième ILO 150.

Les différents exemples et variantes précédemment décrits pour le premier mode de réalisation peuvent s'appliquer à ce deuxième mode de réalisation.

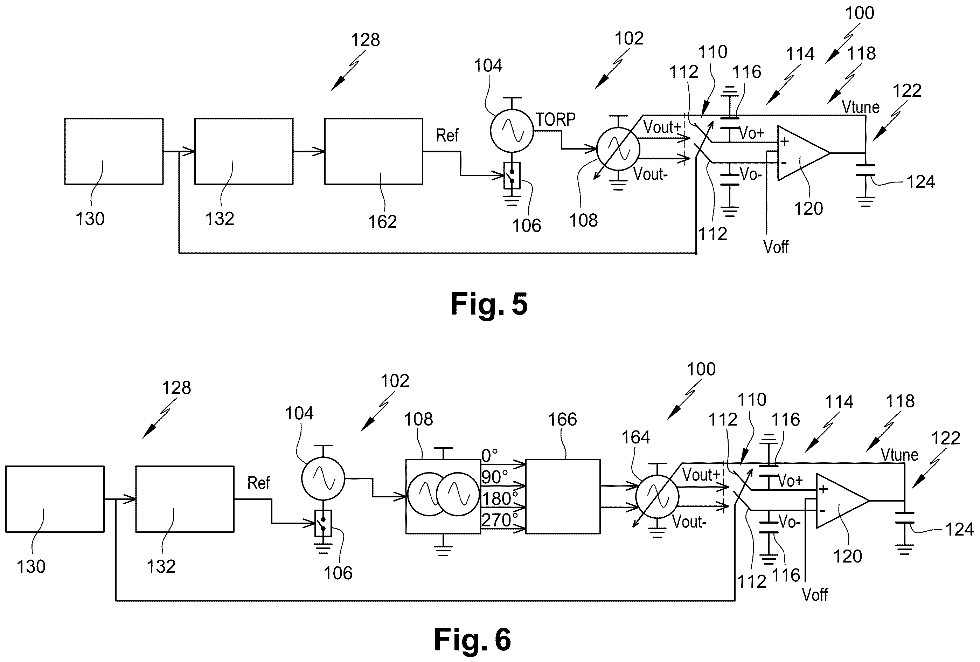

La figure 5 représente schématiquement le dispositif 100 selon un troisième mode de réalisation.

Par rapport au dispositif 100 selon le premier mode de réalisation précédemment décrit, le dispositif 100 selon ce troisièmes mode de réalisation comporte en outre une ligne à retard contrôlé 162, ou VCDL (« Voltage Controled Delay Line » en anglais) couplée à l'entrée de l'oscillateur pulsé 102, et plus particulièrement entre l'entrée de l'oscillateur pulsé 102 et la sortie du générateur 128. Cette VCDL 162 est configurée pour appliquer sur le signal de référence REF un retard équivalent à un déphasage égal à 0° ou 90° ou 180° ou 270° à la fréquence N.$F_{Ref}$.

La VCDL 162 permet d'appliquer un déphasage important de valeur fixe sur le signal de référence Ref, et ainsi choisir le quadrant dans lequel le déphasage engendré par les autres éléments du dispositif 100 est appliqué. Le déphasage appliqué par la VCDL 162 sur le signal de référence Ref est multiplié par N à la sortie du dispositif 100. Par conséquent, pour sélectionner un déphasage de 0°, 90°, 180° ou 270°, le signal de référence Ref est déphasé de [0°, 90°, 180° ou 270°]/N par la VCDL 162. Ceci peut être mis en œuvre, par exemple, en utilisant une VCDL 162 appliquant un retard de valeur sélectionnable correspondant à 0 seconde pour un déphasage de 0°, à $\frac{1}{F_{ref}} \cdot \frac{1}{4N}$ seconde pour un déphasage de 90°, à $\frac{1}{F_{ref}} \cdot \frac{1}{2N}$ seconde pour un déphasage de 180°, et à $\frac{1}{F_{ref}} \cdot \frac{3}{4N}$ seconde pour un déphasage de 270°.

En outre, bien que non représenté sur la figure 5, le dispositif 100 selon le troisième mode de réalisation comporte un circuit de contrôle par exemple similaire au premier circuit de contrôle 136 précédemment décrit.

Par rapport aux premier et deuxième modes de réalisation décrits, le dispositif 100 selon le troisième mode de réalisation permet de générer un déphasage couvrant les quatre quadrants (0 à 90°, 90° à 180°, 180° à 270°, et 270° à 0°) ou situé dans l'un de ces quatre quadrants. Les signaux d'intérêts fournis par le dispositif 100, ayant la fréquence et la phase souhaitées, correspondent aux signaux $V_{out+}$ et $V_{out-}$ obtenus en sortie du premier ILO 108.

Une telle VCDL 162 peut être utilisée au sein du dispositif 100 selon le premier ou le deuxième mode de réalisation précédemment décrit.

En variante, l'utilisation d'un circuit de retard différent de la VCDL 162 peut être envisagée, comme par exemple plusieurs filtres polyphases pouvant être commutés.

Les différents exemples et variantes précédemment décrits pour les premier et deuxième modes de réalisation peuvent s'appliquer à ce troisième mode de réalisation. En outre, le dispositif 100 selon ce troisième mode de réalisation peut comporter plusieurs ILOs couplés en cascade tel que précédemment décrit en lien avec le deuxième mode de réalisation.

La figure 6 représente schématiquement le dispositif 100 selon un quatrième mode de réalisation.

Par rapport au dispositif 100 selon le premier mode de réalisation précédemment décrit, le dispositif 100 selon le quatrième mode de réalisation comporte un deuxième ILO 164. De plus, le premier ILO 108 est ici multi-phasé et comporte plusieurs sorties sur lesquelles des signaux sont délivrés avec des déphasages multiples de 90°. Par exemple, un tel premier ILO 108 peut comporter un oscillateur différentiel I/Q. Sur l'exemple de la figure 6, le premier ILO 108 comporte quatre sorties sur lesquelles les déphasages obtenus sont de 0°, 90°, 180° et 270°. Le dispositif 100 comporte en outre un circuit de sélection 166 permettant de sélectionner l'une des sorties du premier ILO 108 et la coupler à l'entrée d'injection du deuxième ILO 164, et choisir ainsi le quadrant dans lequel le deuxième ILO 164, couplé aux autres éléments du dispositif 100, va appliquer un déphasage contrôlé de la valeur souhaitée via l'application de la tension de commande sur le deuxième ILO 164, comme précédemment décrit pour le premier ILO 108 du dispositif 100 selon le premier mode de réalisation. Dans ce quatrième mode de réalisation, les signaux d'intérêts fournis par le dispositif 100, ayant la fréquence et la phase souhaitées, correspondent aux signaux $V_{out+}$ et $V_{out-}$ obtenus en sortie du deuxième ILO 164.

En outre, bien que non représenté sur la figure 6, le dispositif 100 selon le quatrième mode de réalisation comporte un circuit de contrôle par exemple similaire au premier circuit de contrôle 136 précédemment décrit.

Les différents exemples et variantes précédemment décrits pour les premier et deuxième modes de réalisation peuvent s'appliquer à ce quatrième mode de réalisation.

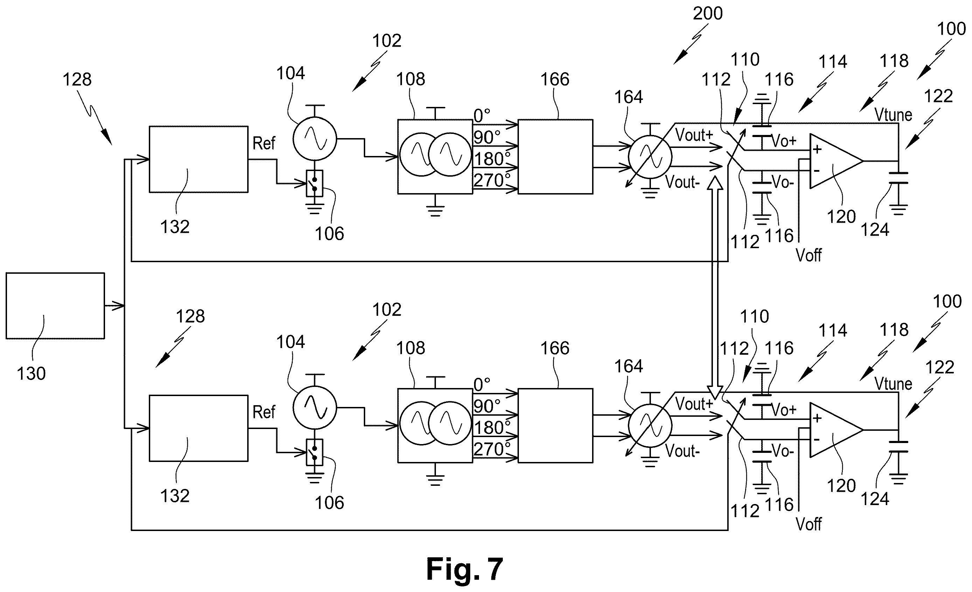

La figure 7 représente schématiquement un dispositif de génération multi-signaux 200 selon un mode de réalisation particulier.

L'architecture du dispositif 100 précédemment décrit peut être utilisée au sein d'un dispositif 200 de génération multi-signaux comprenant plusieurs dispositifs de génération de signal 100 tels que précédemment décrits et configurés pour recevoir en entrée un même signal de référence Ref, avec différentes tensions de décalage appliquées sur les ILOs de ces dispositifs 100. Sur l'exemple de la figure 7, le dispositif 200 comporte deux dispositifs 100 chacun similaire à celui précédemment décrit en lien avec la figure 6 et partageant la même source 130. Étant donné que les dispositifs 100 partagent ici le même signal périodique émis par la source 130, le déphasage généré à la sortie de chaque dispositif 100 est aligné sur la même référence. Cela permet de générer un déphasage relatif stable et précis entre les différentes branches de génération de signaux. Cela est également vrai si les dispositifs 100 sont intégrés dans des circuits intégrés distincts, car le signal issue de la source 130 commune, de fréquence beaucoup plus basse, peut être distribué facilement et avec précision à tous les circuits intégrés séparés, assurant ainsi une cohérence de phase entre eux.

Bien que non représenté sur la figure 7, chacun des dispositifs 100 comporte un circuit de contrôle par exemple similaire au premier circuit de contrôle 136 précédemment décrit.

Un tel dispositif 200 peut former une architecture MIMO ou des réseaux phasés analogiques avec déphasage du signal LO de sortie. Dans l'exemple décrit ici, les signaux d'intérêts ayant la fréquence et la phase souhaitées correspondent aux signaux $V_{out+}$ et $V_{out-}$ obtenus en sortie de du deuxième ILO 164 de chacun des dispositifs 100.

En variante, le dispositif 200 peut comporter des dispositifs 100 selon l'un des autres modes de réalisation précédemment décrits.

Dans tous les modes de réalisation, la phase de calibration peut être mise en œuvre par exemple à chaque démarrage du dispositif 100 ou 200, ou bien à différents intervalles de temps, réguliers ou non.

Les dispositifs 100 et 200 sont particulièrement adaptés aux applications sans fil, filaires ou à guide d'ondes à haut débit, nécessitant une mise en œuvre d'une formation de faisceaux ou un réglage précis de la phase du signal LO, ainsi qu'aux applications radar. L'utilisation d'un signal de référence de fréquence basse qui fixe la référence pour la phase permet la distribution et la synchronisation de générateurs de signaux LO distants de fréquence bien plus grandes, ce qui assure la cohérence de la phase de l'ensemble du système. La boucle de contrôle et de suivi de la phase fournit un mécanisme de stabilisation face aux variations VT et au vieillissement du dispositif. La multiplication de fréquence à nombre entier N élevé permet d'obtenir de très bonnes performances en matière de bruit de phase. Les circuits d'acquisition de verrouillage et de suivi de phase utilisés au sein du dispositif 100 permettent de stabiliser l'état de verrouillage d'un ou plusieurs ILOs au centre de leur courbe de sensibilité, ce qui permet d'obtenir les meilleures performances en matière de bruit de phase.

Dans tous les modes, variantes et exemples de réalisation, le dispositif 100 permet de générer un signal LO en introduisant directement sur ce signal LO, dès sa génération, un déphasage contrôlé et calibré. La génération de signal mise en œuvre par le dispositif 100 peut être basée sur la multiplication de fréquence par un nombre entier d'ordre élevé. Le dispositif 100 peut servir à générer par exemple un signal modulé ou à onde continue dans la gamme des ondes millimétriques (mmW) ou sub-THz, avec un ajustement et un contrôle de phase du signal généré par rapport à un signal d'entrée de référence dont la fréquence est beaucoup plus basse et à partir duquel le signal de sortie est généré. Le déphasage obtenu est contrôlé, stable et précis.

Dans tous les modes de réalisation, le déphase obtenu n'est pas ou très peu impacté par les variations VT subies par le dispositif 100 ou 200.

Dans tous les modes de réalisation, le dispositif 100 ou 200 ne nécessite de réaliser un suivi continu du verrouillage en fréquence du ou des ILOs.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en œuvre pratique des modes de réalisation et variantes décrits est à la portée de la personne du métier à partir des indications fonctionnelles données ci-dessus.

**Revendications**

1. Dispositif de génération de signal (100), comprenant au moins :

- un oscillateur pulsé (102) configuré pour recevoir en entrée un signal périodique de fréquence $F_{Ref}$ et générer sur une sortie un signal TORP correspondant à un train d'oscillations de fréquence égale à $M.F_{Ref}$, de durée inférieure à $T_{Ref} = 1/F_{Ref}$ et répété périodiquement à la fréquence $F_{Ref}$, avec M nombre entier supérieur à 1 ;
- un premier oscillateur verrouillé par injection (108) comprenant au moins une entrée d'injection couplée à la sortie de l'oscillateur pulsé (102) et comprenant au moins deux sorties sur lesquelles des signaux périodiques $V_{out+}$ et $V_{out-}$ de fréquence égale à $N.F_{Ref}$, avec N nombre entier supérieur à 1, et déphasés de 180° l'un par rapport à l'autre sont destinés à être délivrés ;
- un premier échantillonneur (110) configuré pour échantillonner les signaux $V_{out+}$ et $V_{out-}$ à la fréquence $F_{Ref}$ ;
- un premier intégrateur (114) configuré pour délivrer en sortie des signaux $V_{o+}$ et $V_{o-}$ résultant chacun d'une intégration d'un des signaux $V_{out+}$

et $V_{out-}$ échantillonnés à la fréquence $F_{Ref}$ ;
- un premier circuit de conversion (118) comprenant au moins une entrée de commande configurée pour recevoir au moins une tension de décalage $V_{off}$, et configuré pour délivrer un signal de sortie de valeur proportionnelle à la différence de tension $(V_{off} + V_{o+}) - (V_{off} + V_{o-})$ et destiné à être appliqué sur une entrée de contrôle du premier oscillateur verrouillé par injection (108).

2. Dispositif de génération de signal (100) selon la revendication 1, dans lequel le premier circuit de conversion (118) comporte au moins un amplificateur (120) de tension à courant.

3. Dispositif de génération de signal (100) selon l'une quelconque des revendications 1 ou 2, dans lequel le premier circuit de conversion (118) comporte deux entrées de commande configurées pour recevoir chacune l'une des tensions de décalage $V_{off+}$ et $V_{off-}$, et est configuré pour délivrer le signal de sortie de valeur proportionnelle à la différence de tension $(V_{off+} + V_{o+}) - (V_{off-} + V_{o-})$.

4. Dispositif de génération de signal (100) selon l'une quelconque des revendications précédentes, dans lequel le premier échantillonneur (110) comporte au moins deux commutateurs (112) configurés pour être commandés à la fréquence $F_{Ref}$ et recevoir chacun en entrée l'un des signaux $V_{out+}$ et $V_{out-}$.

5. Dispositif de génération de signal (100) selon l'une quelconque des revendications précédentes, dans lequel le premier intégrateur (114) comporte au moins deux capacités électriques (116) comprenant chacune une première électrode sur laquelle l'un des signaux $V_{out+}$ et $V_{out-}$ échantillonnés est destiné à être appliqué et une deuxième électrode sur laquelle un potentiel électrique de référence est destiné à être appliqué.

6. Dispositif de génération de signal (100) selon l'une quelconque des revendications précédentes, comportant en outre un premier circuit de stockage (122) d'une tension de commande du premier oscillateur verrouillé par injection (108), configuré pour appliquer ladite tension de commande sur l'entrée de contrôle du premier oscillateur verrouillé par injection (108).

7. Dispositif de génération de signal (100) selon la revendication 6, dans lequel le premier circuit de stockage (122) comporte au moins une capacité électrique.

8. Dispositif de génération de signal (100) selon l'une quelconque des revendications 6 ou 7, comportant en outre un premier circuit d'initialisation de la valeur de la tension de commande stockée dans le premier circuit de stockage (122).

9. Dispositif de génération de signal (100) selon la revendication 8, dans lequel le premier circuit d'initialisation est configuré pour mettre en œuvre une phase de calibration du dispositif de génération de signal (100) au cours de laquelle les étapes suivantes sont mises en œuvre :

    - déconnecter le premier circuit de stockage (122) vis-à-vis d'une sortie du premier circuit de conversion (118), et déconnecter les sorties du premier oscillateur verrouillé par injection (108) vis-à-vis d'entrées du premier échantillonneur (110) ;
    - coupler un premier circuit de contrôle (136) entre les sorties du premier oscillateur verrouillé par injection (108) et le premier circuit de stockage (122) ;
    - calculer et stocker, dans le premier circuit de stockage (122), une valeur de tension d'initialisation telle que son application sur l'entrée de contrôle du premier oscillateur verrouillé par injection (108) engendre un verrouillage du premier oscillateur verrouillé par injection (108) sur la fréquence $N.F_{Ref}$ et qu'un déphasage entre les signaux périodiques $V_{out+}$ et $V_{out-}$ et le signal TORP soit nul.

10. Dispositif de génération de signal (100) selon la revendication 9, dans lequel le premier circuit de contrôle (136) comporte au moins :

    - un filtre intégrateur (144) configuré pour réaliser un filtrage passe-haut ou passe-bande des signaux $V_{out+}$ et $V_{out-}$ ;
    - un comparateur (146) configuré pour comparer un signal de sortie du filtre intégrateur (144) avec une valeur seuil ;
    - un dispositif de contrôle (148) configuré pour déterminer des valeurs maximum et minimum de la tension de commande du premier oscillateur verrouillé par injection (108) pour lesquelles le premier oscillateur verrouillé par injection (108) peut se verrouiller en fréquence, et pour déterminer la valeur de la tension d'initialisation qui est comprise entre ces valeurs maximum et minimum.

11. Dispositif de génération de signal (100) selon l'une quelconque des revendications précédentes, comportant en outre un circuit (132) de mise en forme de signal configuré pour recevoir en entrée un signal sinusoïdal de fréquence $F_{Ref}$ et pour délivrer sur l'entrée de l'oscillateur pulsé (102) le signal périodique de fréquence $F_{Ref}$ sous la forme d'un signal carré.

12. Dispositif de génération de signal (100) selon l'une quelconque des revendications précédentes, comportant en outre une ligne à retard contrôlé (162) couplée à l'entrée de l'oscillateur pulsé (102) et configurée pour appliquer sur le signal périodique de fréquence $F_{Ref}$ un déphasage égal à 0° ou 90° ou 180° ou 270°.

13. Dispositif de génération de signal (100) selon l'une quelconque des revendications précédentes, comprenant au moins un deuxième oscillateur verrouillé par injection (150, 164) comportant au moins deux entrées d'injection couplées aux sorties du premier oscillateur verrouillé par injection (108).

14. Dispositif de génération de signal (100) selon la revendication 13, dans lequel :

    - le premier oscillateur verrouillé par injection (108) est multi-phasé et comporte plusieurs sorties sur lesquelles des signaux sont délivrés avec des déphasages multiples de 90°, ou
    - le deuxième oscillateur verrouillé par injection (150) fait partie d'une boucle de rétroaction comportant au moins un deuxième échantillonneur (152), un deuxième intégrateur (154), et un deuxième circuit de conversion (156), couplés entre eux de manière analogue au premier échantillonneur (110), au premier intégrateur (114) et au premier circuit de conversion (118) avec le premier oscillateur verrouillé par injection (108).

15. Dispositif de génération multi-signaux (200) comprenant au moins plusieurs dispositifs de génération de signal (100) selon l'une quelconque des revendications précédentes, et configurés pour recevoir en entrée un même signal périodique de fréquence $F_{Ref}$ et différentes tensions de décalage $V_{off}$ chacune destinée à l'un des dispositifs de génération de signal (100).

Fig. 1

Fig. 2

**Fig. 3**

Fig. 4

Fig. 5

Fig. 6

**Fig. 7**

**RAPPORT DE RECHERCHE EUROPEENNE**

Europäisches Patentamt
European Patent Office
Office européen des brevets

Numéro de la demande

EP 25 21 9652

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | BOULMIRAT ABDESSAMAD ET AL: "Lock Detector Integrated in a High Order Frequency Multiplier Operating at 60-GHz-Band in 45nm CMOS SOI Technology", 2020 IEEE/MTT-S INTERNATIONAL MICROWAVE SYMPOSIUM (IMS), IEEE, 4 août 2020 (2020-08-04), pages 944-947, XP033839549, DOI: 10.1109/IMS30576.2020.9223899 * II. Principle of Operation IIIImplementation; page 944 - page 946; figures 1-3 * | 1-15 | INV. H03L7/083 H03L7/091 H03L7/099 H03L7/24 |
| A | YOO SEYEON ET AL: "19.2 A PVT-robust -39dBc 1kHz-to-100MHz integrated-phase-noise 29GHz injection-locked frequency multiplier with a 600 W frequency-tracking loop using the averages of phase deviations for mm-band 5G transceivers", 2017 IEEE INTERNATIONAL SOLID-STATE CIRCUITS CONFERENCE (ISSCC), IEEE, 5 février 2017 (2017-02-05), pages 324-325, XP033073609, DOI: 10.1109/ISSCC.2017.7870392 * page 324; figure 19.2.2 * | 1-15 | |

DOMAINES TECHNIQUES RECHERCHES (IPC)

H03L
H03D
H03B

-/--

Le présent rapport a été établi pour toutes les revendications

| Lieu de la recherche | Date d'achèvement de la recherche | Examinateur |
|---|---|---|
| La Haye | 6 janvier 2026 | Wienema, David |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
.....................................................................................
& : membre de la même famille, document correspondant

EPO FORM 1503 03.82 (P04C02)

page 1 de 2

# EP 4 761 115 A1

Europäisches Patentamt

European Patent Office

Office européen des brevets

## RAPPORT DE RECHERCHE EUROPEENNE

Numéro de la demande

EP 25 21 9652

### DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | JANY CLEMENT ET AL: "A Programmable Frequency Multiplier-by-29 Architecture for Millimeter Wave Applications", IEEE JOURNAL OF SOLID-STATE CIRCUITS, IEEE, USA, vol. 50, no. 7, 1 juillet 2015 (2015-07-01), pages 1669-1679, XP011585481, ISSN: 0018-9200, DOI: 10.1109/JSSC.2015.2411623 [extrait le 2015-06-23] * II. Operating Principle IV. Circuit Design; page 1670 - page 1675; figures 1-4, 13 * | 1-15 | |

-----

DOMAINES TECHNIQUES RECHERCHES (IPC)

Le présent rapport a été établi pour toutes les revendications

| Lieu de la recherche | Date d'achèvement de la recherche | Examinateur |
|---|---|---|
| La Haye | 6 janvier 2026 | Wienema, David |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

................................................................
& : membre de la même famille, document correspondant

EPO FORM 1503 03.82 (P04C02)

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 3624343 A1
- US 2023224138 A1

- WO 2013079685 A1

**Littérature non-brevet citée dans la description**

- **KANOUN, M et al.** A 5.8 GHz fully integrated BiCMOS SiGe:C injection-locked-oscillator-based active phase shifter for energy beamforming. *Analog Integr Circ Sig Process*, 2021, vol. 106, 363-374
- **YOO, SEYEON et al.** A Low-Integrated-Phase-Noise 27-30-GHz Injection-Locked Frequency Multiplier With an Ultra-Low-Power Frequency-Tracking Loop for mm-Wave-Band 5G Transceivers. *IEEE Journal of Solid-State Circuits*, 2018, vol. 53, 375-388

- **L.-Y. CHEN et al.** A Ka-Band 256-QAM Ninefold Sub-Harmonically Injection-Locked CMOS I/Q Modulator Using Pulsed Oscillator. *2024 IEEE/MTT-S International Microwave Symposium - IMS 2024*, 2024, 50-53